Europäisches Patentamt

European Patent Office

Office européen des brevets

(11) Publication number: **0 272 390**
**A2**

## EUROPEAN PATENT APPLICATION

(21) Application number: 87114577.7

(22) Date of filing: 06.10.87

(51) Int. Cl.⁴ **H01L 23/14** , H01L 23/04 , H01L 23/48

(30) Priority: 25.11.86 JP 280225/86

(43) Date of publication of application:
29.06.88 Bulletin 88/26

(84) Designated Contracting States:
**DE FR GB**

(71) Applicant: **KABUSHIKI KAISHA TOSHIBA
72, Horikawa-cho Saiwai-ku
Kawasaki-shi Kanagawa-ken 210(JP)**

(72) Inventor: **Shindo, Masamichi
56, Zenbu-cho Asahi-ku
Yokohama-shi Kanagawa-ken(JP)**

(74) Representative: **Ritter und Edler von Fischern,
Bernhard,Dipl.-Ing. et al
HOFFMANN - EITLE & PARTNER
Arabellastrasse 4
D-8000 München 81(DE)**

(54) Packages for a semiconductor device.

(57) A semiconductor chip (5) is mounted and fixed onto a stem (1). A wiring substrate (7) is mounted and fixed around said semiconductor chip (5) on said stem (1). A number of through-holes (1b, 7a) are provided so as to penetrate the stem and the wiring substrate, and a number of lead-pins (3) are inserted into said respective through-holes to extrude from the lower surface of said stem (1). Said semiconductor chip and said wiring substrate are covered by and hermetically sealed to metallic shell (10). The input-output terminals of the electric circuits formed on the semiconductor chip(5) are connected respectively to said lead-pins (3) through wiring layer formed on said wiring substrate (7). In such construction, it is possible to obtain a positive hermetic sealing which is adaptable to multi-pin construction, thereby to reduce the manufacturing cost of semiconductor packages.

F I G. 2

# PACKAGES FOR A SEMICONDUCTOR DEVICE

## BACKGROUND OF THE INVENTION

This invention relates to semiconductor packages, and more particularly to a type of semiconductor package suitable for use as a package for LSI having a number of output terminals.

A typical example of a semiconductor package using pins for mounting the printed circuit board inserted therein is DIP (Dual In-line Package). However, the number of these output pins is limited, so that about 60 pins are the upper limit, more than 60 pins being practically unsuitable.

Therefore, for the purpose of using a number of pins, PGA (Pin Grid Array) is generally used wherein many pins project from the under surface of the semiconductor package.

The PGA comprises the so-called ceramic type PGA using a laminate including a number of metal layers onto a ceramic substrate, or the so-called plastic type PGA using a plastic printed-circuit board instead of the wiring on said ceramic substrate in order to reduce the manufacturing cost thereof.

However, since said ceramic type PGA comprises the ceramic laminate type package, the manufacturing process becomes generally complicated and costly. Further, since materials on the basis of tungsten are used for wiring, the resistance of this wiring becomes higher to cause a higher heating value, and the ceramic materials used have a relatively large heat capacity as well as a moderate heat radiation.

Though said plastic type PGA can be manufactured less costly than said ceramic type PGA, this type of PGA must be resin-sealed by means of organic materials for the purpose of protecting the semiconductor tips when these are mounted. Consequently, stress is occasionally applied from this sealing materials, and the characteristics of resins cause an incomplete isolation from the outer air so that a complete hermetic sealing cannot be obtained. Accordingly, the plastic type PGA is disadvantageous in that its fidelity is lower than that of said ceramic type PGA and that the size of tip which can be mounted therein is limited.

## SUMMARY OF THE INVENTION

The present invention helps to eliminate the above described disadvantages and the object thereof is to provide a semiconductor package which can be provided with a larger number of pins in order to be applied to the larger sizes of semiconductor tips while being completely hermetically sealed, and which can be manufactured at a lower cost.

The above object is achieved according to the present invention by a semiconductor package which hermetically seals the corresponding semiconductor tip while the input and output terminals of the electric circuit formed on said semiconductor tip are held in the electrical connection with the outer circuits, said semiconductor package comprising a metal stem having a semiconductor tip mounted at the center portion thereof and having a number of through-holes around the semiconductor tip; a wiring substrate attached on the upper surface of said stem, said substrate having a wiring layer of a predetermined pattern formed on the surface thereof and through-holes each corresponding to said through-holes of said stem; lead pins passing through said through-holes of said stem and said wiring substrate and protruding below said stem; and a shell for covering and hermetically sealing said semiconductor tip and said wiring substrate, wherein the input and output terminals of the electronic circuits formed on said semiconductor tip are connected with said wiring layer and this wiring layer is connected with said lead-pins.

## BRIEF DESCRIPTION OF THE DRAWINGS

In the accompanying drawings:

Fig. 1 is a perspective view of a semiconductor package according to the present invention, a part thereof being broken away for showing the interior portion thereof; and

Fig. 2 is a vertical cross-sectional view of the semiconductor package shown in Fig. 1.

## DESCRIPTION OF THE PREFERRED EMBODIMENT

The semiconductor package according to the present invention shown in the drawings comprises a plate-like stem 1 made of iron or ferroalloy such as 42 alloy, with a rectangular opening 1a formed at the substantially central portion thereof. A number of through-holes 1b, 1b,... are arranged around said opening 1a in three arrays from the circumference of said stem 1, said through-holes 1b each having the diameter of about 1 mm for passing therethrough the respective lead-pins 3. On the outer side of these arrays of through-holes 1b, a circumferential portion 1c extends from a step portion.

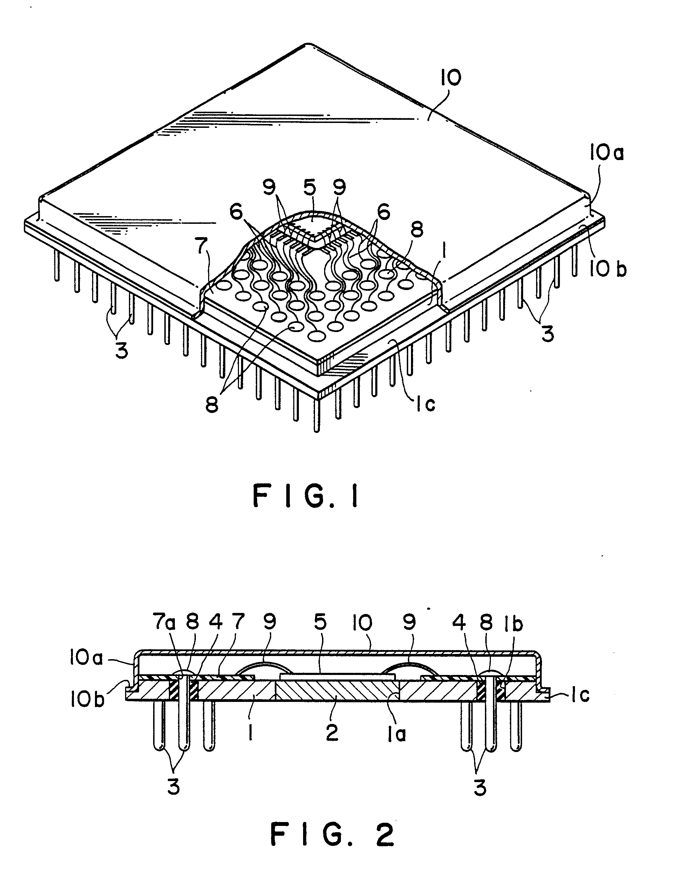

A heat sink member 2 (not shown in Fig. 1) of materials having a high heat radiation such as copper is seal-attached into said opening 1a of said stem 1. The improved heat radiation is thus obtained by using the heat sink member 2 and mounting the semiconductor chip 5 on the upper side of the heat sink 2 as will be described hereinbelow. Further, the lead-pins 3 inserted into respective through-holes 1a of stem 1 are hermetically sealed therein at their respective upper portions by sealing materials 4 (not shown in Fig. 1) while protruding below the lower surface of the stem 1.

Said semiconductor chip 5 is mounted and attached by soldering for example onto the upper surface of said heat sink 2. A wiring substrate 7 is fixed onto the upper surface of said stem 1. The size of this wiring substrate 7 is slightly smaller than that of said stem 1, so that, when the wiring substrate 7 is mounted on the upper surface of the stem 1, said circumferential portion 1c of stem 1 extends outside of the wiring substrate 7 for hermetically sealing thereon the circumference of the shell 10 as will be described hereinbelow. Wiring layer 6 (not shown in Fig. 2) having a predetermined wiring pattern is formed on said wiring substrate 7.

The wiring substrate 7 comprises in general organic monolayer or laminate substrate of glass-epoxy resin, polyimide resin and the like, but ceramic substrates such as alumina or AlN can be used in combination with the materials of said stem 1.

Through-holes 7a, 7a, ... for connection with one end of said wiring layer 6 are formed in the wiring substrate 7 respectively at the points corresponding to the through-holes 1b, 1b, ... bored in said stem 1. The upper portions of lead-pins 3 are inserted into respective through-holes 7a, with the upper end surface of each lead-pins 3 being connected with respective one end of the wiring layer 6 by means of junction materials 8 such as solder.

Respective bonding pads as input-output terminals on said semiconductor chip 5 are connected with the other ends of the wiring layer 6 on said wiring substrate 7 through respective bonding wires 9 thereby to connect respective input-output terminals of semiconductor chip 5 with said respective lead-pins 3.

A shell 10 such as metal cover having the vertical end wall 10a and the horizontal portion 10b extending therefrom is mounted on the upper surface of said wiring substrate 7. The inner side surface of said vertical end wall 10a abuts against the peripheral side surface of said wiring substrate 7, while said horizontally extending portion 10b of said shell 10 is superposed and hermetically sealed by electric welding, for example, onto the peripheral portion 1c of said stem 1.

Accordingly, the semiconductor package according to the present invention renders possible the complete hermetic sealing which has been considered impossible with said plastic type PGA due to its proper characteristics.

Further, even in the case where the shell 10 is formed of ceramic materials such as alumina, the hermetic sealing using glass between stem 1 and shell 10 can be carried out by equalizing the heat expansion coefficients of stem 1 and shell 10.

In this type of semiconductor device, since the package is made of metal, the potential of the rear side of semiconductor chip 5 would become the same as that of stem 1 if the semiconductor chip 5 is connected with stem 1 by means of conductive materials such as solder. In order to prevent this disadvantage, isolating organic materials generally used in the assembling process of semiconductor elements can be used for the attachment of semiconductor chip 5, or otherwise, after the sealing of shell 10, stem 1 and shell 10 can be coated with organic resins except lead-pins 3, thereby to isolate the rear side surface of semiconductor chip 5 from lead-pins 3.

With the above described construction of semiconductor package according to the present invention, it can be manufactured less costly than the ceramic type PGA and the plastic type PGA, and in addition thereto, its positive hermetic sealing assures a complete hermetic condition. Further, the adaptability to the larger type of packages substantially equivalent to that of ceramic PGA and the multi-pin construction substantially equivalent to that of plastic type PGA can be obtained according to the present invention though the latter characteristics are rather inferior to ceramic type PGA.

Further, the heat radiation is maximized and the electric capacity is minimized by utilizing polyimide resin or glass-epoxide resin as materials of wiring substrate.

In addition, in the cases of heretofore known ceramic type PGA and plastic type PGA, the design of package corresponding to the kind thereof has to be carried out at first. On the contrary, according to the present invention, only the exchange of wiring substrate is necessary for adapting it to various kinds of PGA used provided that the number of pins remain the same, so that PGA packages can be provided readily and less costly.

## Claims

1. A semiconductor package which hermetically seals the corresponding semiconductor chip while the input and output terminals of the electric circuit formed on said semiconductor chip are held in the electrical connection with the outer circuits, characterized by comprising:

a metal stem (1) having a semiconductor chip (5) mounted at the center portion thereof and having a number of through-holes (1b) around said semiconductor chip;

a wiring substrate (7) attached on the upper surface of said stem, said substrate having a wiring layer (6) of a predetermined pattern formed on the surface thereof and through-holes (7a) each corresponding to said through-holes (1b) of the stem;

lead-pins (3) passing through said through-holes (1b, 7a) of said stem and said wiring substrate and protruding below said stem; and

a shell (10) for covering and hermetically sealing said semiconductor chip (5) and said wiring substrate (7),

wherein the input and output terminals of the electronic circuits formed on said semiconductor chip (5) are connected with said wiring layer (6) and this wiring layer (6) is connected with said lead-pins (3).

2. The semiconductor package as claimed in claim 1, wherein said stem (1) is made of ferroalloys.

3. The semiconductor package as claimed in claim 1, wherein the portion of stem (1) mounting thereon semiconductor chip (5) is made of metal materials having a high heat radiation.

4. The semiconductor package as claimed in claim 3, wherein said metal material having a high heat radiation is copper.

5. The semiconductor package as claimed in claim 1, wherein said lead-pins (3) are fixed in said through-holes (1b) by filling therein sealing materials (4) consisting of glass.

6. The semiconductor package as claimed in claim 1, wherein said wiring substrate (7) comprises a monolayer or laminate substrate consisting of glass-epoxy resin.

7. The semiconductor package as claimed in claim 1, wherein said wiring substrate (7) comprises a monolayer or laminate substrate consisting of polyimide resin.

8. The semiconductor package as claimed in claim 1, wherein said stem (1) and said shell (10) are connected with each other by electric welding.

9. The semiconductor package as claimed in claim 1, wherein said stem (1) and said shell (10) are hermetically sealed with each other by filling glass therebetween.

F I G. 1

F I G. 2